Europäisches Patentamt

European Patent Office

Office européen des brevets

(11) Publication number: **0 385 492**
**A2**

## EUROPEAN PATENT APPLICATION

(21) Application number: **90104070.9**

(51) Int. Cl.5: **H03M 7/50**

(22) Date of filing: **02.03.90**

(30) Priority: **03.03.89 GB 8904949**

(43) Date of publication of application:
**05.09.90 Bulletin 90/36**

(84) Designated Contracting States:
**DE FR IT SE**

(71) Applicant: **MOTOROLA, INC.**
**1303 East Algonquin Road**
**Schaumburg, IL 60196(US)**

(72) Inventor: **Sonnard, Jean-Daniel**
**Avenue des Figuiers 02**
**CH-1007 Lausanne(CH)**

(74) Representative: **Holt, Michael et al**
**MOTOROLA European Intellectual Property**
**Operations Jays Close Viables Industrial**
**Estate**
**Basingstoke Hampshire RG22 4PD(GB)**

(54) **Method and apparatus for data expansion.**

(57) A data expansion circuit (30) for expanding data comprising a sign bit, a segment defined by n bits and an interval defined by m bits, said circuit comprising:

input means (32) for receiving said data;

segment decoder means (66) for decoding said segment and to thereby generate signals in dependence thereon;

logic array means (52) for generating an expanded data sequence comprising the m interval bits at a first bit position according to a data expansion law and in dependence on said signals from the segment decoder;

determining means for determining if said expanded data is negative;

data inversion means (120) for generating the inverse of negative expanded data;

output means for outputting said expanded data sequence; characterized by said logic array means (52) further comprising:

inverting means (150, 152, 154) for generating the inverse of said sign bit; and

introduction means for introducing the inverted sign bit at a second bit position less significant than said first bit position to thereby generate the resulting expanded data sequence.

A method for expanding data comprising a sign bit, a segment defined by n bits and an interval defined m bits is also disclosed.

FIG.2A

FIG.2B

## Method and Apparatus for Data Expansion

### Field of the Invention

This invention relates to data expansion. Data expansion and compression techniques are well known in the field of data communication.

The present invention is particularly, though not exclusively, concerned with data expansion such as may be performed in a central office telephone exchange or in a PABX.

### Background Art

In a known exchange a two-wire subscriber line is coupled by means of a BORSCHT interface circuit to the PCM highway of the exchange.

For each subscriber line there is a corresponding interface circuit, comprising a high voltage circuit coupled directly to the two-wire subscriber line for interfacing the relatively high voltage of the subscriber line with the lower line voltage of the rest of the interface circuit and a low voltage circuit coupled to the four-wire PCM highway for performing functions including definition of the current feed characteristic and balanced to unbalanced two-to-four-wire conversion as well as the more usual coding and filtering functions. The low voltage circuit comprises an analog part and a digital part coupled to the PCM highway. The voice signals on the PCM highway are time multiplexed, with typically an eight bit word in each time slot. However, typically thirteen/fourteen bit data samples are required in the digital part in order to reduce contamination due to noise. Therefore data compression must be performed in the transmit direction so that a thirteen/fourteen bit data sample is compressed to an eight bit word and conversely data expansion must be performed in the receive direction whereby the eight bit word is expanded to a thirteen/fourteen bit data sample. The two data compression/expansion laws most widely used are A-law, the European standard and Mu-law, the North American standard. This invention relates particularly to a method of data expansion and apparatus therefor.

In a typical data expansion circuit, for positive input data the eight bit word is expanded to thirteen bits according to A-law or fourteen bits according to Mu-law. However, for negative input data additional steps are required to generate the two's complement, such as a one's complement generation step followed by an "add one" step. To perform the "add one" step, this requires a fourteen bit adder comprising one adder cell per bit and since there are some twenty transistors in each cell, a large number of transistors are required. This substantial hardware requirement creates a further disadvantage in that the related delay time is significant.

It is the object of the present invention to provide an improved method of expanding data and apparatus therefor wherein the above disadvantages may be obviated.

### Statement of the Invention

In accordance with a first aspect of the present invention there is provided a method of expanding digital data comprising the steps of:

receiving data comprising a sign bit, a segment defined by n bits and an interval defined by m bits;

decoding said segment in segment decoder means thereby generating signals in dependence thereon;

generating an expanded data sequence comprising the m interval bits at a first bit position according to a data expansion law and in dependence on said signals from the segment decoder;

determing if the expanded data sequence is negative and generating the inverse of said expanded data sequence in response to said determination;

outputting the expanded data sequence; said method characterized by the steps of:

generating the inverse of said sign bit;

introducing the inverted sign bit at a second bit position less significant than said first bit position to thereby generate the resulting expanded data sequence.

In accordance with a second aspect of the present invention there is provided a data expansion circuit for expanding data comprising a sign bit, a segment defined by n bits and an interval defined by m bits, said circuit comprising:

input means for receiving said data;

segment decoder means for decoding said segment and to thereby generate signals in dependence thereon;

logic array means for generating an expanded data sequence comprising the m interval bits at a first bit position according to a data expansion law and in dependence on said signals from the segment decoder ;

determining means for determining if said expanded data is negative;

data inversion means for generating the inverse of negative expanded data;

output means for outputting said expanded data sequence; characterized by said logic array means further comprising:

inverting means for generating the inverse of said sign bit; and

introduction means for introducing the inverted sign bit at a second bit position less significant than said first bit position to thereby generate the resulting expanded data sequence.

It will be appreciated that by reducing the circuit area of the hardware, the related delay time is also reduced.

In addition by removing the need of an "addition" statement in the software required to perform such a data expansion, the related execution time is also reduced.


## Brief Description of the Drawings


A method of expanding data and a data expansion circuit in accordance with the invention will now be described, by way of example only, with reference to the accompanying drawings, in which:

Figure 1 shows a schematic block diagram of an examplary subscriber line interface circuit; and

Figure 2 shows a schematic diagram of the data expansion circuit of the interface circuit of figure 1 in accordance with the present invention.


## Description of Specific Embodiment of the Invention


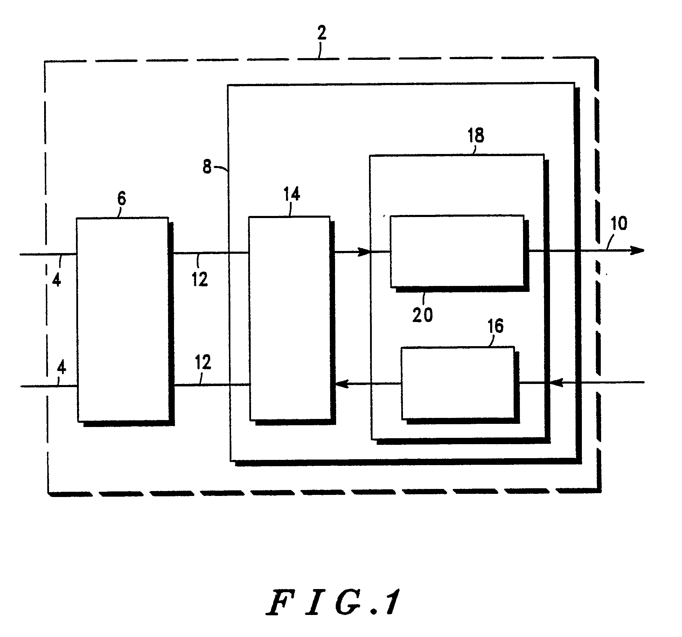

Referring firstly to Figure 1, in a telephone exchange each two-wire subscriber line 4 is coupled to the PCM highway 10 by a subscriber line interface circuit 2 comprising a high voltage circuit 6 and a low voltage circuit 8. The high voltage circuit and low voltage circuit are interconnected by control lines 12.

A known example of a subscriber line interface circuit is produced and sold by Motorola, Inc. and its subsidiaries.

The high voltage circuit 6 is a relatively simple circuit for interfacing the relatively high voltage of the subscriber line 4 with the lower line voltages of the rest of the interface circuit 2. The low voltage circuit 8 comprises an analog part 14 for performing analog functions such as two-to-four wire conversion in which differential signals on the two-wire subscriber lines are converted to four-wire unbalanced signals and vice-versa, setting of the DC loop characteristic, off hook detection, trimming for common mode rejection and generation, anti-aliasing and reconstruction filtering and analog-to-digital & digital-to-analog conversion, and a digital part 18 for performing digital signal processing and functions such as gain and frequency adjustment and data compression and expansion. To achieve data expansion and compression the digital part 18 comprises a data expansion circuit 16 and a data compression circuit 20 each coupled to the PCM highway 10 via PCM interface circuits (not shown). The mode of operation of such a digital part 8 is more fully described in the European Application No. 86905346 entitled "Subscriber Line Card Arrangement", the disclosure of which is hereby incorporated herein by reference.

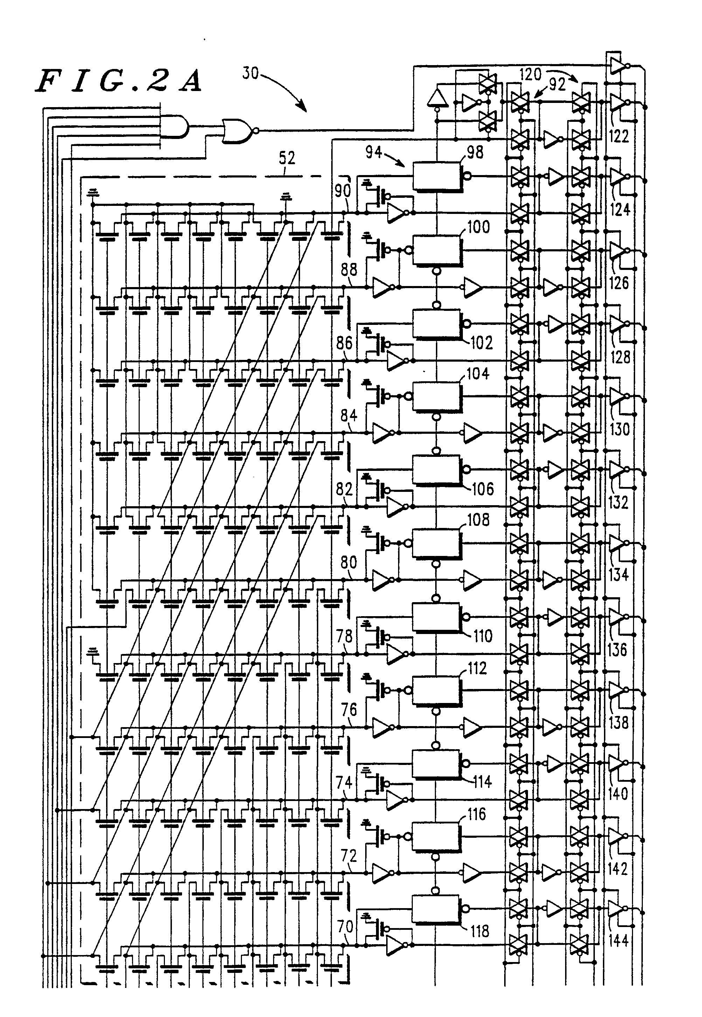

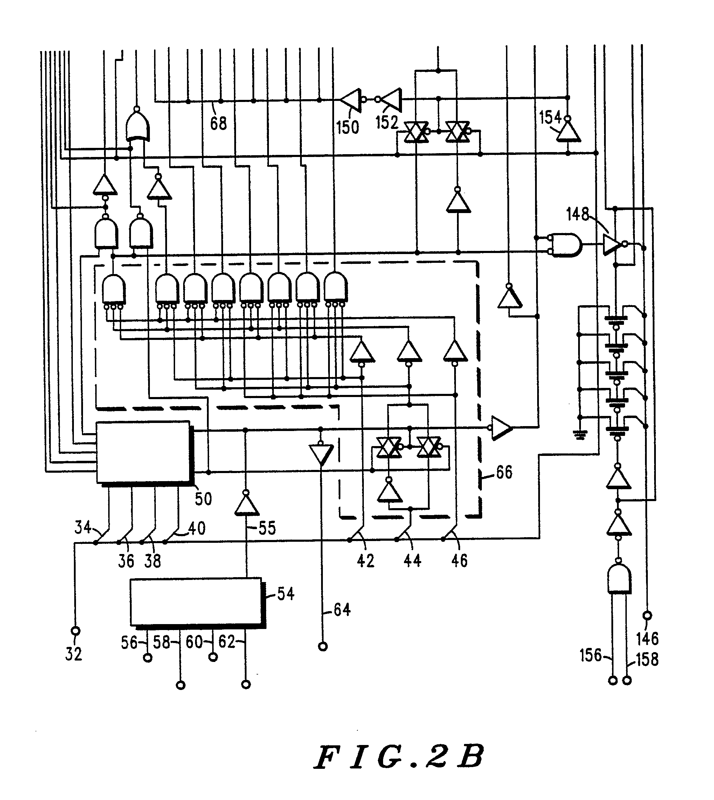

Referring now also to Figure 2, compressed eight bit data passes into the data expansion circuit 30 via a data bus 32 having eight bit lines 34, 36, 38, 40, 42, 44, 46, 48 coupled to the PCM highway 10. The data comprises a sign bit S, which passes along the most significant bit line 48, a segment defined by three bits $S_1$, $S_2$, $S_3$ which pass along bit lines 42, 44, 46 respectively and an interval defined by four bits $I_1$, $I_2$, $I_3$, $I_4$ which pass along bit lines 34, 36, 38, 40 respectively. All eight bit lines 34-48 are coupled to a programmable logic array (PLA) 52.

The four interval bit lines 34, 36, 38, 40 are coupled via an interval decoder 50 to the PLA 52. The interval decoder 50 inverts the interval bits $I_1$, $I_2$, $I_3$, $I_4$ if necessary according to the chosen expansion law.

The three segment bit lines 42, 44, 46 are coupled to a segment decoder 66. The segment decoder 66 is coupled to the PLA 52 such that in operation, signals from the segment decoder 66 drive the PLA 52 to introduce the interval bits $I_1$, $I_2$, $I_3$, $I_4$ from the interval decoder 50 into the correct ranks of an expanded data sequence according to either A-law or Mu-law. The PLA 52 also introduces 0 into the other bit ranks for the most significant bits and a special pattern depending on the sign bit S and its inverse s for the least significant bits. This least significant bit pattern will be described more fully below.

The sign bit line 48 is coupled to the PLA 52 at the node B and also via a second sign bit line 68 along which the inverse of the sign bit s passes (s = NOT (S)).

In the preferred embodiment by simple programming it is possible to select either one of A- or Mu-law data expansion and this is achieved by a law select decoder 54, controlled by an eight bit address signal passing along an eight bit address bus 56 together with signals CLC, $MU_n$ GRESET fed along lines 58, 60, 62 respectively.

The outputs 70-90 from the PLA 52 are coupled to a block of switches 92 directly and also via an adder 94. The adder 94 comprises a group of eleven interconnected adder cells 98-118 and is utilised only in the case of Mu-law expansion to subtract thirty-three (i.e. add 1 1111 1101 1111) from the expanded data sequence generated by the PLA 52.

The block of switches 92 are coupled to the ALAW signal line 64 and the law select decoder 54 via the select line 55 such that the state of the switches is dependent upon which one of the expansion laws has been selected. Thus the switches 92 control whether the expanded data sequence outputted from the PLA 52 is directed through the adder 94 to a one's complement generator 120 coupled to the switches 92, for Mu-law expansion, or directly to the one's complement generator 120, for A-law expansion.

The one's complement generator 120 comprises a group of latches which are coupled to associated output buffers 122-144 whose outputs couple to the internal data bus 146. The one's complement generator 120 is connected between the sign bit line 48 and a line coupled to the first adder cell 98 of the adder 94 such that the one's complement is generated if the resulting data is negative: for A-law data expansion the one's complement is generated in response to the signal on the sign bit line 48 corresponding to negative input data (i.e. S = 1), for Mu-law data expansion the one's complement is generated in response to the most significant bit produced by the adder cell 98 corresponding to negative expanded data. The internal data bus 146 of the preferred embodiment is nineteen bits wide (18-0) and this is to ensure that there is a sufficiently large number of data bits to reduce errors due to noise contamination. However, the useful range of data with respect to the external PCM highway 10, is fourteen bits for Mu-law and thirteen bits for A-law.

The fourteen bit data sample for Mu-law comprises thirteen bits which are identical to those thirteen bits for A-law, that is: a sign bit, the twelve bits outputted from the output buffers 122-144 and in addition comprises one bit outputted from a buffer 148 which is coupled to the law select decoder 54. The remaining five least significant bits of the data are purely fill-out bits.

The mode of operation of the exemplary data expansion circuit will now be described.

At the beginning of the operation a global reset operation is performed by applying a signal GRESET on the line 62. This selects A-Law data expansion.

The eight bit input data passes along the data bus 32 from the PCM interface (not shown) into the expansion circuit 30. The three bits $S_1$, $S_2$, $S_3$ defining the segment are decoded in the segment decoder 66 and the four interval bits $I_1$, $I_2$, $I_3$, $I_4$ are fed into the interval decoder 50 for selective inversion. The inversion of the sign bit is generated on the second sign bit line 68 by gates 150, 152, 154.

The input data is expanded by introducing the interval bits $I_1$, $I_2$, $I_3$, $I_4$ at the appropriate ranks of the expanded data sequence, according to the signals generated in the segment decoder 66 on decoding the segment $S_1$, $S_2$, $S_3$ and in accordance with A-Law. In addition the inverse of the sign bit (s) followed by sign bits (S's) are introduced for the lowest significant bits via the sign bit line 48 and the second sign bit line 68 coupled to the PLA 52. Table 1 shows the bit-pattern of the expanded data generated by the PLA 52 according to A-law and in accordance with the present invention.

| S3 | S2 | S1 | msb | Expanded Data Sequence | | | | | | | | | | | | lsb | |
|----|----|----|-----|---|---|---|---|---|---|---|---|---|---|---|---|-----|---|
| 0 | 0 | 0 | 0 | 0 | 0 | 0 | 0 | 0 | 0 | 0 | $I_4$ | $I_3$ | $I_2$ | $I_1$ | s | s | |
| 0 | 0 | 1 | 0 | 0 | 0 | 0 | 0 | 0 | 0 | 1 | $I_4$ | $I_3$ | $I_2$ | $I_1$ | s | s | |
| 0 | 1 | 0 | 0 | 0 | 0 | 0 | 0 | 0 | 1 | $I_4$ | $I_3$ | $I_2$ | $I_1$ | s | S | S | Table 1 A-Law |
| 0 | 1 | 1 | 0 | 0 | 0 | 0 | 0 | 1 | $I_4$ | $I_3$ | $I_2$ | $I_1$ | s | S | S | S | |
| 1 | 0 | 0 | 0 | 0 | 0 | 0 | 1 | $I_4$ | $I_3$ | $I_2$ | $I_1$ | s | S | S | S | S | |
| 1 | 0 | 1 | 0 | 0 | 0 | 1 | $I_4$ | $I_3$ | $I_2$ | $I_1$ | s | S | S | S | S | S | |
| 1 | 1 | 0 | 0 | 0 | 1 | $I_4$ | $I_3$ | $I_2$ | $I_1$ | s | S | S | S | S | S | S | |
| 1 | 1 | 1 | 0 | 1 | $I_4$ | $I_3$ | $I_2$ | $I_1$ | s | S | S | S | S | S | S | S | |

It will be appreciated that by introducing the sign bit S and its inverse s the expansion sequence in Table 1 corresponds to both positive input data (S = 0, s = 1) and negative input data (S = 1, s = 0): no distinction having so far been made. The method of data expansion is similiar for positive input data and negative input data, the only difference being that an additional step of one's complement generation for negative input data is required.

Since A-law data expansion has been selected the state of the switches 92 is such that expanded data outputted from the PLA 52 passes into the one's complement generator 120. If the input data is positive (S = 0) no data inversion is generated and the expanded data is latched directly into the group of latches of the one's complement generator 120. However for negative input data (S = 1) the one's complement is generated and the resulting inverted data is subsequently latched.

In response to signals EXP and CLB applied to lines 156, 158 respectively by a controller (not shown) the resulting expanded data passes into the internal data bus 146 via the output buffers 122-144.

The above description describes a method of data expansion according to A-law; however, after having performed the initial global reset (GRESET) operation and having set the expansion law to A-law, MU-law can be selected by applying appropriate signals ADRC, CLC and $MU_n$ to the law select decoder 54.

The method of data expansion according to Mu-law is similar to that of A-law, in that the input data is expanded by introducing the interval bits $I_1$, $I_2$, $I_3$, $I_4$ of the input data at the appropriate ranks of the expanded data sequence, according to the signals generated in the segment decoder 66 on decoding the segment $S_1$, $S_2$, $S_3$ and in accordance with Mu-law. Also the inverse of the sign bit (s) followed by sign bits (S's) are introduced for the lowest significant bits via the sign bit line 48 and the second bit line 68 coupled to the PLA. However, the bit-pattern of the expanded data which is generated in the PLA 52 has a different form: Table 2 shows the bit-pattern of the expanded data generated by the PLA 52 according to Mu-law and in accordance with the present invention.

**Table 2 — Mu-law**

| S3 | S2 | S1 | msb | Expanded Data Sequence | | | | | | | | | | | | | lsb |
|----|----|----|-----|---|---|---|---|---|---|---|---|---|---|---|---|---|-----|
| 0 | 0 | 0 | 0 | 0 | 0 | 0 | 0 | 0 | 0 | 0 | 1 | $I_4$ | $I_3$ | $I_2$ | $I_1$ | s | s |
| 0 | 0 | 1 | 0 | 0 | 0 | 0 | 0 | 0 | 0 | 1 | $I_4$ | $I_3$ | $I_2$ | $I_1$ | s | S | S |
| 0 | 1 | 0 | 0 | 0 | 0 | 0 | 0 | 0 | 1 | $I_4$ | $I_3$ | $I_2$ | $I_1$ | s | S | S | S |
| 0 | 1 | 1 | 0 | 0 | 0 | 0 | 0 | 1 | $I_4$ | $I_3$ | $I_2$ | $I_1$ | s | S | S | S | S |
| 1 | 0 | 0 | 0 | 0 | 0 | 0 | 1 | $I_4$ | $I_3$ | $I_2$ | $I_1$ | s | S | S | S | S | S |
| 1 | 0 | 1 | 0 | 0 | 0 | 1 | $I_4$ | $I_3$ | $I_2$ | $I_1$ | s | S | S | S | S | S | S |
| 1 | 1 | 0 | 0 | 0 | 1 | $I_4$ | $I_3$ | $I_2$ | $I_1$ | s | S | S | S | S | S | S | S |
| 1 | 1 | 1 | 0 | 1 | $I_4$ | $I_3$ | $I_2$ | $I_1$ | s | S | S | S | S | S | S | S | S |

Once Mu-law has been selected, signals from the law select decoder 54 change the state of the block of switches 92 such that the expanded data outputted from the PLA 52 is directed through the adder 94 whereby thirty-three is subtracted from the expanded data. The resulting expanded data then passes into the one's complement generator 120. Depending on the most significant bit of the resulting expanded data, which is outputted from the first adder cell 98 and which distinguishes negative and positive data, if the

6

resulting expanded data is negative, the one's complement is generated and the resulting inverted data is latched into the group of data latches, however if the resulting expanded data is positive, no data inversion is generated and the data is latched directly into the data latches.

The resulting expanded data passes into the internal data bus 146 according to the same operation as that for A-law.

In the arrangement of the invention, by allowing a simple logic conversion of the least significant bits of the A-law or Mu-law expanded data to be performed in the PLA, such that the effect is to 'add one' for negative values, the necessity of having a fourteen bit full adder to perform an 'add one' step at the end of the expansion process for negative values is avoided. As a result the full adders' related delay time is avoided by eliminating the necessity of having an 'add one' step, the 'addition' statement in the software program is no longer required, thereby avoiding its related execution time. Thus the overall time taken for data expansion has been significantly reduced.

## Claims

1. A method of expanding digital data comprising the steps of:
receiving data comprising a sign bit, a segment defined by n bits and an interval defined by m bits;
decoding said segment in segment decoder means thereby generating signals in dependence thereon;
generating an expanded data sequence comprising the m interval bits at a first bit position according to a data expansion law and in dependence on said signals from the segment decoder;
determining if the expanded data sequence is negative and generating the inverse of said expanded data sequence in response to said determination;
outputting the expanded data sequence; said method characterized by the steps of:
generating the inverse of said sign bit;
introducing the inverted sign bit at a second bit position less significant than said first bit position to thereby generate the resulting expanded data sequence.

2. A method of expanding digital data according to claim 1 wherein further characterized by introducing the sign bit at one or more third bit positions less significant than the second bit position.

3. A method of expanding digital data according to claim 1 wherein said data expansion law is A-Law.

4. A method of expanding digital data according to claim 1 wherein said data expansion law is MU-law, said method including an additional step of subtracting thirty-three from the resulting expanded data sequence.

5. A method of expanding digital data according to claims 3 and 4 wherein said method includes before the step of decoding said segment an additional step of selecting one of said data expansion laws.

6. A data expansion circuit (30) for expanding data comprising a sign bit, a segment defined by n bits and an interval defined by m bits, said circuit comprising:
input means (32) for receiving said data;
segment decoder means (66) for decoding said segment and to thereby generate signals in dependence thereon;
logic array means (52) for generating an expanded data sequence comprising the m interval bits at a first bit position according to a data expansion law and in dependence on said signals from the segment decoder;
determining means for determining if said expanded data is negative;
data inversion means (120) for generating the inverse of negative expanded data;
output means for outputting said expanded data sequence; characterized by said logic array means (52) further comprising:
inverting means (150, 152, 154) for generating the inverse of said sign bit; and
introduction means for introducing the inverted sign bit at a second bit position less significant than said first bit position to thereby generate the resulting expanded data sequence.

7. A data expansion circuit for expanding data according to claim 6 wherein the introduction means further introduces the sign bit at one or more third bit positions less significant than the second bit position.

8. A data expansion circuit for expanding data according to claim 6 wherein said data expansion law is A-law.

9. A data expansion circuit for expanding data according to claim 6 wherein said data expansion law is MU-law, whereby said data expansion circuit further comprises subtracting means (94) coupled to said logic array means for subtracting thirty-three from said resulting expanded data sequence.

10. A data expansion circuit for expanding data according to claims 8 and 9 wherein said data circuit further comprises switching means (54, 56, 58, 60, 62) for selecting one of said data expansion laws.

*F I G . 1*

FIG.2A

*FIG.2B*